# EUROPEAN PATENT APPLICATION

(11) **EP 4 716 389 A1**
(43) Date of publication of application: **25.03.2026**
(21) Application number: 24806165.7
(22) Date of filing: 12.03.2024
(51) Int. Cl.: H05K 7/20

(54) **TWO-PHASE LIQUID COOLING SYSTEM DESIGN METHOD, AND TWO-PHASE LIQUID COOLING SYSTEM**

(30) Priority: 17.05.2023 CN 202310559592
(71) Applicant: ZTE CORPORATION, Shenzhen, Guangdong 518057 (CN)
(72) Inventor: TAO, Cheng, Shenzhen, Guangdong 518057 (CN); LIU, Fan, Shenzhen, Guangdong 518057 (CN); ZHOU, Xiaodong, Shenzhen, Guangdong 518057 (CN)
(74) Representative: Chimini, Francesco
(86) International application number: PCT/CN2024/081250
(87) International publication number: WO 2024/234805

(57) **Abstract**

Provided are a design method for a two-phase liquid-cooling system and a two-phase liquid-cooling system. The design method for a two-phase liquid-cooling system comprises the following steps: determining, according to set power of a heating element on each branch under standard operating conditions, a first total flow rate and a first total flow resistance of the system under standard operating conditions; matching a first pump according to the first total flow rate and the first total flow resistance; evaluating the system at least under harsh operating conditions after selecting the first pump for the system; and determining, according to the evaluation result, whether the system design satisfies requirements.

## Description

### Cross-Reference to Related Application

The present invention claims the priority of Chinese Patent Application CN202310559592X, filed on 17 May 2023 and entitled "Two-Phase Liquid Cooling System Design Method and Two-Phase Liquid Cooling System", the disclosure of which is incorporated herein by reference in its entirety.

### Technical Field

The present invention relates to the technical field of liquid cooling, and in particular, to a design method for a two-phase liquid-cooling system and a two-phase liquid-cooling system.

### Background

With the continuous increase in chip power consumption, cooling methods have evolved from air cooling to single-phase liquid cooling and then to two-phase liquid cooling. Pump-driven two-phase liquid cooling technology has evolved from gravity heat pipes and refrigeration air conditioning systems, utilizing the phase change of the cooling medium to absorb heat. It offers great heat transfer potential but poses high design difficulty. Currently, in the communications field, such as parallel single-board systems in carrier equipment, when the load in some branches of the system changes, the flow resistance of the branches and the system changes synchronously, causing the flow rates in branches of the system to be redistributed, which in turn affects the flow and heat dissipation in branches that have not undergone any load change. To address this, the prior art typically adds flow rate adjustment devices to the system to regulate the flow rates in branches of the system when the system load changes, preventing the flow rates in branches that have not undergone load changes from being affected. However, this method increases the system cost.

### Summary

The main objective of embodiments of the present invention is to provide a design method for a two-phase liquid-cooling system and a two-phase liquid-cooling system, so as to solve the problem of how to reasonably design the system so that the flow rate distribution in each branch of the system can satisfy the heat dissipation requirement of the system under different operating conditions.

The embodiments of the present invention propose a design method for a two-phase liquid-cooling system, comprising the following steps: determining, according to set power of a heating element on each branch under standard operating conditions, a first total flow rate and a first total flow resistance of the system under standard operating conditions; matching a first pump according to the first total flow rate and the first total flow resistance; evaluating the system at least under harsh operating conditions after selecting the first pump for the system; and determining, according to the evaluation result, whether the system design satisfies requirements.

The embodiments of the present invention further provide a two-phase liquid-cooling system. The system comprises: a pipeline system, comprising a main pipeline and a plurality of parallel branches, the plurality of branches being used for correspondingly cooling a plurality of cold plates; and a pump body, provided on the main pipeline; wherein the flow rate of the pump body can satisfy the heat dissipation and flow rate requirements of each of the branches under both standard operating conditions and harsh operating conditions.

### Brief Description of the Drawings

To describe the technical solutions in the embodiments of the present invention or in the existing technology more clearly, the following briefly describes the accompanying drawings required for describing the embodiments or the existing technology. Apparently, the accompanying drawings in the following description show merely some embodiments of the present invention, and a person of ordinary skill in the art may still derive other drawings from these accompanying drawings without creative efforts.
Fig. 1 is a schematic flowchart of a first embodiment of a design method for a two-phase liquid-cooling system according to an embodiment of the present invention;
Fig. 2 is a schematic flowchart of a second embodiment of a design method for a two-phase liquid-cooling system according to an embodiment of the present invention;
Fig. 3 is a schematic flowchart of a third embodiment of a design method for a two-phase liquid-cooling system according to an embodiment of the present invention;
Fig. 4 is a schematic flowchart of a fourth embodiment of a design method for a two-phase liquid-cooling system according to an embodiment of the present invention;
Fig. 5 is a schematic diagram of a flow resistance of a two-phase liquid-cooling system under standard operating conditions according to an embodiment of the present invention;
Fig. 6 is a schematic diagram of a flow resistance of a two-phase liquid-cooling system in the harshest operating condition according to an embodiment of the present invention.

The implementation of the objectives, functional features, and advantages of the present invention will be further described with reference to the accompanying drawings in combination with embodiments.

### Detailed Description of the Embodiments

Hereinafter, the technical solutions in the embodiments of the present invention will be described clearly and thoroughly with reference to the accompanying drawings of the embodiments of the present invention. Obviously, the embodiments as described are some of the embodiments of the present invention, and are not all of the embodiments. On the basis of the embodiments in the present invention, all other embodiments obtained by a person of ordinary skill in the art without inventive effort shall all belong to the scope of protection of the present invention.

It should be noted that directional indications involved in the embodiments of the present invention are only used for explaining relative position relationships, movement situations or the like between the various components in a specific posture. If the specific posture changes, the directional indications change accordingly.

In addition, when there are descriptions related to "first" and "second" in the embodiments of the present invention, the descriptions of "first" and "second" are only used for the purpose of describing, and cannot be understood as indication or implication of relative importance or implicit indication of the number of specified technical features. Thus, features defined by "first" and "second" may explicitly or implicitly comprise at least one of the features. In addition, the technical solutions of various embodiments may be combined with each other but need to be based on the technical solutions that can be implemented by a person of ordinary skill in the art. When a combination of the technical solutions is contradictory or cannot be implemented, it should be considered that such a combination of the technical solutions does not exist and does not fall within the protection scope of the present invention.

With the continuous increase in chip power consumption, cooling methods have evolved from air cooling to single-phase liquid cooling and then to two-phase liquid cooling. Pump-driven two-phase liquid cooling technology has evolved from gravity heat pipes and refrigeration air conditioning systems, utilizing the phase change of the cooling medium to absorb heat. It offers great heat transfer potential but poses high design difficulty. Currently, in the communications field, such as parallel single-board systems in carrier equipment, when the load in some branches of the system changes, the flow resistance of the branches and the system changes synchronously, causing the flow rates in branches of the system to be redistributed, which in turn affects the flow and heat dissipation in branches that have not undergone any load change. To address this, the prior art typically adds flow rate adjustment devices to the system to regulate the flow rates in branches of the system when the system load changes, preventing the flow rates in branches that have not undergone load changes from being affected. However, this method increases the system cost.

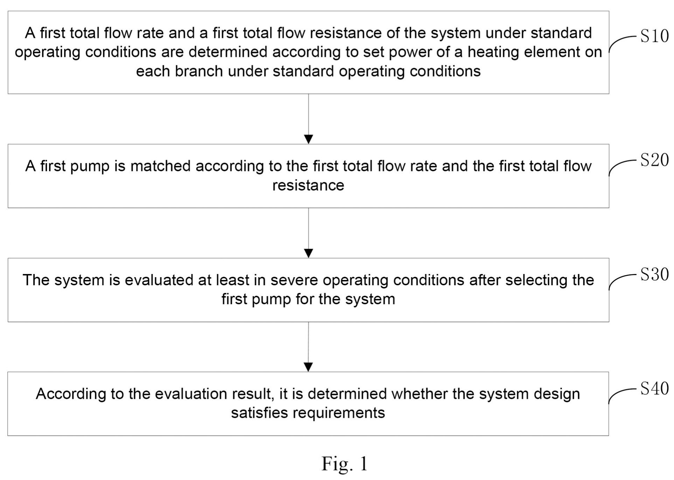

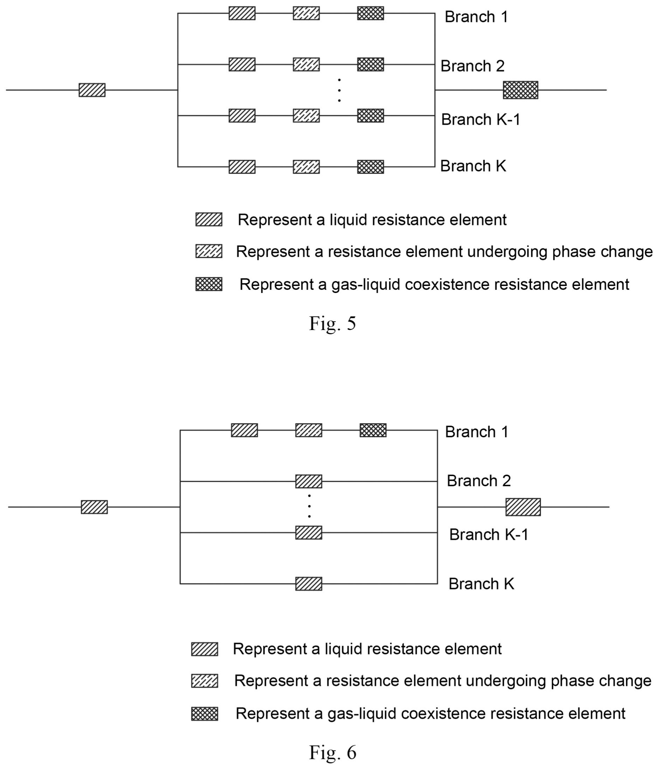

**In** view of this, an embodiment of the present invention provides a design method for a two-phase liquid-cooling system, so as to solve the problem of how to reasonably design the system so that the flow rate distribution in each branch of the system can satisfy the heat dissipation requirement of the carrier equipment under different operating conditions. Figs. 1 to 4 are schematic flowcharts of a design method for a two-phase liquid-cooling system according to an embodiment of the present invention; Figs. 5 and 6 are schematic diagrams of a load of a two-phase liquid-cooling system in different operating modes according to an embodiment of the present invention.

Please refer to Fig. 1, Fig. 1 is a schematic flowchart of a first embodiment of a design method for a two-phase liquid-cooling system according to an embodiment of the present invention.

**In** the present embodiment, the design method for the two-phase liquid-cooling system includes the following steps:
S10: a first total flow rate and a first total flow resistance of the system under standard operating conditions are determined according to set power of a heating element on each branch under standard operating conditions;
S20: a first pump is matched according to the first total flow rate and the first total flow resistance;
according to the first total flow rate and the first total flow resistance, a point may be determined in a flow rate head coordinate system, and matching the first pump means that a head-flow rate curve of the pump needs to pass through the point. Theoretically, there are multiple curves that pass through a given point, that is, there are multiple pumps that meet the first total flow and the first total flow resistance. Therefore, when selecting a pump, one should aim to choose a pump with a flatter head-flow rate curve, i.e. a pump with a small change in head and a larger change in flow rate. This is because when the heat load of a branch in the system changes, the flow resistance of that branch decreases, causing the total flow rate of the system to increase while the head decreases slightly. In other words, when the heat load of a branch in the system changes, the change in the total flow resistance of the system is small, whereas the change in the total flow rate is large.
S30: the system is evaluated at least in severe operating conditions after selecting the first pump for the system;
S40: according to the evaluation result, it is determined whether the system design satisfies requirements.

**In** the present embodiment, during system design, the first total flow rate and first total flow resistance of the system under standard operating conditions are first determined on the basis of the set power of the heating elements in each branch under standard operating conditions. Then, on the basis of the first total flow rate and the first total flow resistance, the first pump with a gentle head-flow rate curve is selected. After selecting the first pump for the system, the system is evaluated at least under harsh operating conditions; on the basis of the evaluation result, it is determined whether the system design satisfies the requirements. In this way, the first total flow rate and the first total flow resistance are first determined on the basis of the heat load conditions of the system under standard operating conditions; pump selection is then performed on the basis of the first total flow rate and the first total flow resistance; further, on the basis of the selected first pump, the system is evaluated at least under harsh operating conditions; and on the basis of the evaluation result, it is determined whether the system design meets the requirements. This ensures that the system can satisfy the heat dissipation requirements under standard operating conditions as well as under harsh operating conditions. Specifically, when the heat load in some branches of the system changes under harsh operating conditions, causing the flow rate in those branches to change, the total flow rate in the system changes synchronously, thereby reducing the flow rate change in branches that have not undergone any load change under harsh operating conditions, keeping the flow rate in branches that have not undergone any load change under harsh operating conditions stable, so that branches that have not undergone any load change under harsh operating conditions can still dissipate heat normally, avoiding the impact of flow rate in branches that have not undergone any load change under harsh operating conditions from being affected by heat load changes in other branches. Thus, by means of reasonable design, the flow rate distribution in each branch of the system can satisfy the heat dissipation requirements of the system under different operating conditions.

Please refer to Fig. 5, Fig. 5 is a schematic diagram of a flow resistance of a system under standard operating conditions. Under standard operating conditions, all branches in the system perform normal heat dissipation, with the total flow rate of the system being Q1 and the flow rate of a branch 1 being q1. Under harsh operating conditions, some branches in the system will experience reduced power consumption or power failure, while under the harshest operating conditions, only one branch performs normal heat dissipation, and the remaining branches experience power failure. Please refer to Fig. 6, Fig. 6 is a schematic diagram of the flow resistance of a system under the harshest operating condition. Under the harshest operating condition, the branch 1 performs normal heat dissipation, while the remaining branches experience power failure. The total flow rate of the system is Q1', and the flow rate of the branch 1 is q1'. Since the remaining branches other than the branch 1 experience power failure, the flow resistance of those remaining branches decreases, causing the flow rates in those remaining branches to increase significantly. **If** the flow rate of the system does not increase synchronously, it will lead to q1' being less than q1, i.e., the flow rate of the branch 1 decreases, thereby affecting the heat dissipation of the branch 1. To this end, in the embodiments of the present invention, under harsh operating conditions, when the heat load in some branches of the system changes, causing the flow rate in those branches to increase, the total flow rate of the system increases synchronously to satisfy the increased flow rate requirement in the branches, thereby keeping the flow rate in branches that have not undergone any load change stable under harsh operating conditions, so that branches that have not undergone any load change can still perform normal heat dissipation under harsh operating conditions, avoiding the flow rate in branches that have not undergone any load change from being affected by heat load changes in other branches under harsh operating conditions.

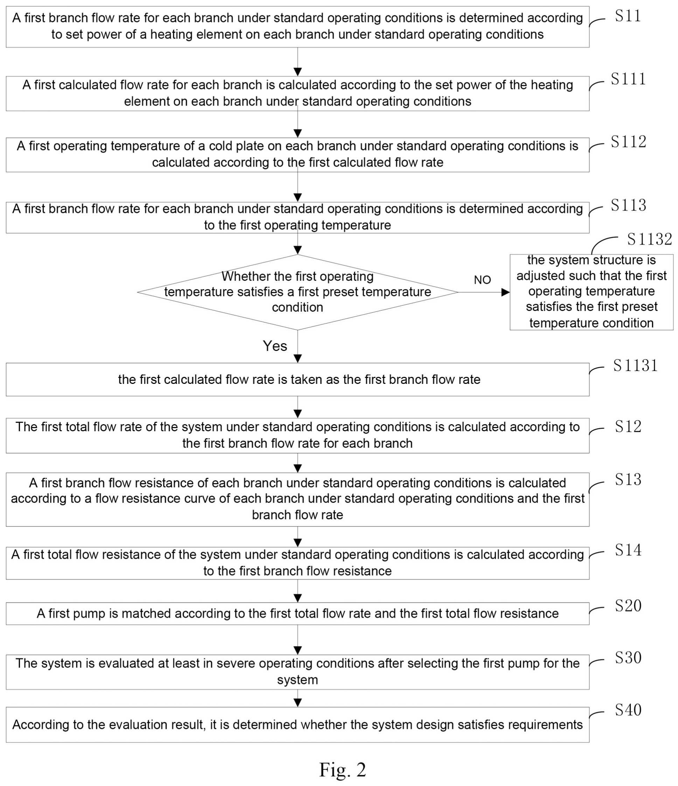

Please refer to Figs. 1 and 2, Fig. 2 is a schematic flowchart of a second embodiment of a design method for a two-phase liquid-cooling system according to an embodiment of the present invention.

**In** the present embodiment, step S10 comprises:
S11: a first branch flow rate for each branch under standard operating conditions is determined according to set power of a heating element on each branch under standard operating conditions;
the set power can be adjusted according to design requirements. Specifically, when initially calculating the flow rate of each branch, the set power is generally calculated according to the maximum power of the heating element, so as to ensure that the calculated flow rate satisfies the maximum heat dissipation requirement of the branch.
S12: the first total flow rate of the system under standard operating conditions is calculated according to the first branch flow rate for each branch.

**In** the present embodiment, the first branch flow rate for each branch under standard operating conditions is determined according to the set power of the heating element on each branch under standard operating conditions, and then the first branch flow rates for various branches are added to calculate the first total flow of the system under standard operating conditions, so as to facilitate subsequent pump selection.

### Step S11 comprises:

S111: a first calculated flow rate for each branch is calculated according to the set power of the heating element on each branch under standard operating conditions.

When calculating the first calculated flow rate of each branch under standard operating conditions, the system dryness needs to be determined, wherein the system dryness refers to the ratio of the vapor phase mass to the total mass of the system. The value of the system dryness should consider the flow boiling heat transfer effect and the heat dissipation requirements of the heating element, while also taking into account the changes in the total flow rate of the system when the operating condition of the system changes. It is generally taken as 0.1 to 0.4, and may be higher in some scenarios.

S112: a first operating temperature of a cold plate on each branch under standard operating conditions is calculated according to the first calculated flow rate;
there are multiple methods for calculating the first operating temperature of the cold plate on the basis of the first calculated flow rate, and the first operating temperature may be calculated by means of a heat transfer empirical formula, and may also be calculated by means of numerical simulation, which is not limited in the present invention.

S113: a first branch flow rate for each branch under standard operating conditions is determined according to the first operating temperature.

**In** the present embodiment, when the first calculated flow rate is calculated, it is assumed that all the heat of the heating element is absorbed by the liquid, However, actually, a part of the heat of the heating element is absorbed by the liquid, and a part of the heat of the heating element is absorbed by the cold plate, so that the temperature of the cold plate increases, and the temperature of the cold plate should not exceed a design temperature, so as to prevent overheating of the cold plate; therefore, after the first calculated flow rate is calculated, it should be determined whether the first calculated flow satisfies the heat dissipation requirements of the cold plate, and therefore, the first calculated flow is calculated first, then the first operating temperature of the cold plate is calculated according to the heat transfer empirical formula, and then the first operating temperature is calculated according to the first operating temperature, and the first branch flow rate for each branch under standard operating conditions is determined, so as to ensure that the first branch flow rate satisfies the heat dissipation requirement of each branch under standard operating conditions.

### Step S113 comprises:

S1131: when the first operating temperature satisfies a first preset temperature condition, the first calculated flow rate is taken as the first branch flow rate;
**In** order to prevent overheating of the cold plate, generally, an operating temperature of the cold plate should be less than a design temperature, and therefore, when the first operating temperature is less than a first preset temperature, it is determined that the first operating temperature satisfies the first preset temperature condition. Certainly, in other embodiments, the first operating temperature may also be not higher than the first preset temperature.

S1132: when the first operating temperature does not satisfy the first preset temperature condition, the system structure is adjusted such that the first operating temperature satisfies the first preset temperature condition.

There are many ways to adjust the structure of the system, such as changing the size of the cold plate of the branch or changing the pipe diameter of the branch, which is not limited in the embodiments of the present invention; in addition, when the first operating temperature is not less than the first preset temperature, it indicates that the cold plate is overheated, and it is determined that the first operating temperature does not satisfy the first preset temperature condition, certainly, in other embodiments, the first operating temperature is greater than the first preset temperature.

**In** the present embodiment, when the first operating temperature satisfies the first preset temperature condition, it indicates that the first calculated flow satisfies the heat dissipation requirement of the system, then the first calculated flow rate is used as the first branch flow rate, so as to perform subsequent calculation. When the first operating temperature does not satisfy the first preset temperature condition, it indicates that the first calculated flow rate does not comply with the heat dissipation requirement of the system, and therefore, the system structure is adjusted to change the flow resistance of the system, so as to increase the flow rate of the system, thereby enabling the first calculated flow to comply with the heat dissipation requirements of the system, i.e. the first operating temperature satisfies the first preset temperature condition.

**In** order to calculate the total flow resistance of the system under standard operating conditions, specifically, after step S11, step S10 comprises:
S13: a first branch flow resistance of each branch under standard operating conditions is calculated according to a flow resistance curve of each branch under standard operating conditions and the first branch flow rate.

Please refer to Fig. 5. Under standard conditions, the flow resistance curve of each branch refers to the curve of the resistance of each resistance element on the branch varying with the flow rate, which is fitted from multiple data points. The flow resistance curve of each branch includes a single-phase flow resistance curve and a two-phase flow resistance curve. The single-phase flow resistance curve refers to the curve of the resistance of the resistance component varying with the flow rate under all-liquid conditions, and the two-phase flow resistance curve refers to the curve of the resistance of the resistance component varying with the flow rate under gas-liquid conditions. The flow resistance elements include frictional resistance, elbows, pipe crimping sections, and standard fittings (such as quick-disconnects + cold plate inlets/sealing blade inlets), etc. Additionally, there are multiple methods for calculating the flow resistance curve of each branch, which may be obtained by means of correlation formulas or may be obtained by means of numerical simulation, which is not limited in the embodiments of the present invention.

S14: a first total flow resistance of the system under standard operating conditions is calculated according to the first branch flow resistance.

**In** the present embodiment, the first branch flow resistance of each branch under standard operating conditions is calculated by means of the flow resistance curve of each branch under standard operating conditions and the first branch flow rate, and then the first total flow resistance of the system under standard operating conditions is calculated by adding the first branch flow resistances of the branches. Certainly, in other embodiments, it may also be that the flow resistance curve of each branch is first fitted to obtain the total flow resistance curve of the system under standard operating conditions, and then the first total flow resistance of the system under standard operating conditions is calculated by means of the total flow resistance curve of the system and the first total flow rate.

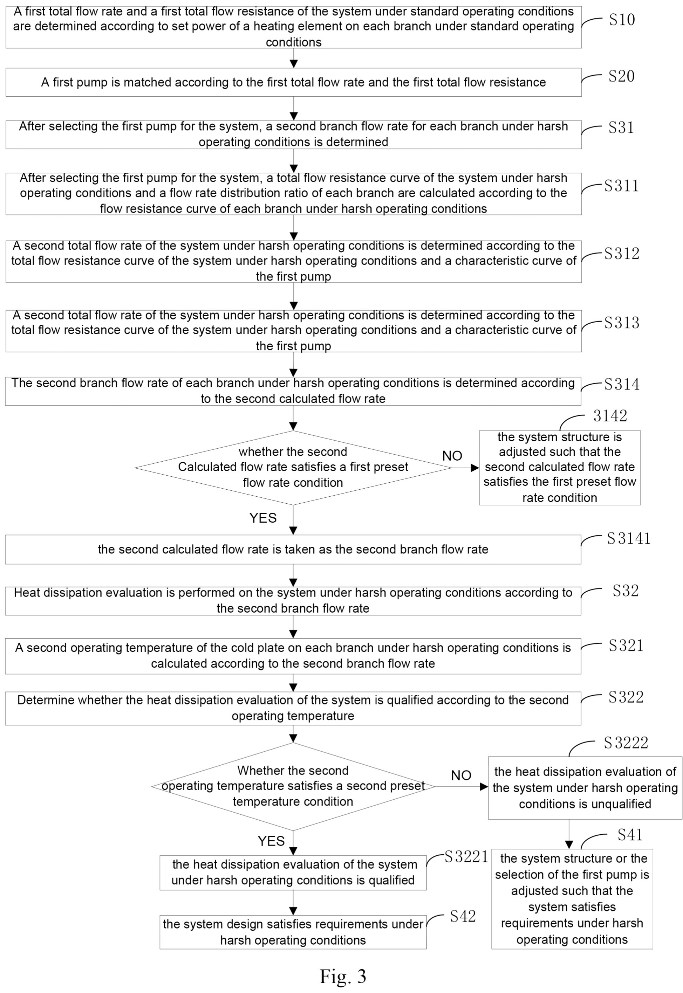

Please refer to Figs. 1 and 3, Fig. 3 is a schematic flowchart of a third embodiment of a design method for a two-phase liquid-cooling system according to an embodiment of the present invention.

**In** the present embodiment, step S30 comprises:
S31: after selecting the first pump for the system, a second branch flow rate for each branch under harsh operating conditions is determined;
S32: heat dissipation evaluation is performed on the system under harsh operating conditions according to the second branch flow rate;
Step S40 comprises:
   S41: when the heat dissipation evaluation of the system under harsh operating conditions is unqualified, the system structure or the selection of the first pump is adjusted such that the system satisfies requirements under harsh operating conditions.

There are many ways to adjust the structure of the system, such as changing the size of the cold plate of the branch or changing the pipe diameter of the branch, which is not limited in the embodiments of the present invention.

S42: when the heat dissipation evaluation of the system under harsh operating conditions is qualified, it is determined that the system design satisfies requirements under harsh operating conditions.

**In** the present embodiment, because the first pump is selected according to the first total flow rate and the first total flow resistance under standard operating conditions, theoretically, the first pump satisfies system requirements under standard conditions, but does not necessarily satisfy system requirements under harsh conditions, in order to ensure that the selected first pump satisfies system requirements under harsh operating conditions, after the first pump is selected for the system, the second branch flow of each branch under harsh operating conditions is determined, and the heat dissipation of the system under harsh operating conditions is evaluated according to the second branch flow; when the flow rate of each branch is the second branch flow rate, it is determined whether the heat dissipation of the system under harsh operating conditions satisfies requirements; if the heat dissipation evaluation of the system under harsh operating conditions is qualified, it indicates that the flow rate of the second branch satisfies the heat dissipation requirement of the system, that is, the system can satisfy both the heat dissipation requirements under standard operating conditions and the heat dissipation requirements of the system under harsh operating conditions; if the heat dissipation estimation of the system under harsh operating conditions is unqualified, it indicates that the flow rate of the second branch cannot satisfy the heat dissipation requirement of the system, to this end, the flow of each branch is increased by adjusting the system structure or the first pump, so that the flow of the second branch complies with the heat dissipation requirement of the system, i.e., making the heat dissipation evaluation of the system under harsh operating conditions qualified.

When the heat dissipation evaluation of the system under harsh operating conditions is unqualified, it is preferably considered that the selection of the pump does not satisfy the requirements, and the first pump is adjusted to be a pump with a flatter head-flow rate curve; and in cases where the selection of the pump is limited or there is no other selection, the system structure is adjusted.

Step S31 comprises:
S311: after selecting the first pump for the system, a total flow resistance curve of the system under harsh operating conditions and a flow rate distribution ratio of each branch are calculated according to the flow resistance curve of each branch under harsh operating conditions.

Please refer to Fig. 6, under harsh operating conditions, the flow resistance curve of each branch refers to the curve of the resistance of each resistance component on the branch varying with the flow rate, which is fitted from multiple data points. The flow resistance curve of each branch includes a single-phase flow resistance curve and a two-phase flow resistance curve. The single-phase flow resistance curve refers to the curve of the resistance of the resistance component varying with the flow rate under all-liquid conditions, and the two-phase flow resistance curve refers to the curve of the resistance of the resistance component varying with the flow rate under gas-liquid conditions. The flow resistance elements include frictional resistance, elbows, pipe crimping sections, and standard fittings (such as quick-disconnects + cold plate inlets/sealing blade inlets), etc. Additionally, there are multiple methods for calculating the flow resistance curve of each branch, which may be obtained by means of correlation formulas or may be obtained by means of numerical simulation, which is not limited in the embodiments of the present invention. Further, after a branch in the system is powered off, a heating element in the branch does not generate heat any longer, and a liquid on the branch does not change phase, so that a flow resistance curve of the branch is a single-phase flow resistance curve.

S312: a second total flow rate of the system under harsh operating conditions is determined according to the total flow resistance curve of the system under harsh operating conditions and a characteristic curve of the first pump.

The characteristic curve of the pump refers to the relationship of the head, power, efficiency, and the like of the system varying with the flow rate. In the head-flow rate coordinate system, the head-flow rate curve of the first pump is a downward-sloping curve, while the total flow resistance curve of the system is an upward-sloping curve. The intersection point of the two is the operating flow rate of the system under harsh operating conditions. When the total flow resistance curve under harsh operating conditions intersects with the head-flow rate curve of the first pump, the flow rate at the intersection point is the second total flow rate.

S313: a second total flow rate of the system under harsh operating conditions is determined according to the total flow resistance curve of the system under harsh operating conditions and a characteristic curve of the first pump;

S314: the second branch flow rate of each branch under harsh operating conditions is determined according to the second calculated flow rate.

**In** the present embodiment, the flow resistance curve for each branch is first obtained on the basis of the resistance elements on each branch under harsh operating conditions. Then, the total flow resistance curve of the system under harsh operating conditions and the flow distribution ratio for each branch are calculated on the basis of the flow resistance curve of each branch. Next, the second total flow rate of the system under harsh operating conditions is determined on the basis of the total flow resistance curve of the system under harsh operating conditions and the characteristic curve of the first pump. Furthermore, the second calculated flow rate for each branch is calculated on the basis of the flow distribution ratio for each branch under harsh operating conditions and the second total flow rate. It is then determined whether to set the second calculated flow rate as the second branch flow rate. **In** this manner, by calculating the second calculated flow rate, it is possible to determine in advance whether the flow distribution under harsh operating conditions satisifies the requirements, thereby avoiding the continuation of subsequent calculations when the flow does not satisfy the requirements, which would otherwise lead to the need for recalculations later, thereby helping to save calculation time.

Step S314 comprises:
S3141: when the second calculated flow rate satisfies a first preset flow rate condition, the second calculated flow rate is taken as the second branch flow rate; and
S3142: when the second calculated flow rate does not satisfy the first preset flow rate condition, the system structure is adjusted such that the second calculated flow rate satisfies the first preset flow rate condition.

There are many ways to adjust the structure of the system, such as changing the size of the cold plate of the branch or changing the pipe diameter of the branch, which is not limited in the embodiments of the present invention.

**In** the present embodiment, to ensure the heat dissipation of the system, the flow rate on each branch should generally not be less than the design flow rate. Therefore, when the second calculated flow rate is not less than the first preset flow rate, it indicates that the second calculated flow rate satisfies the first preset flow rate condition. In this case, the flow distribution of the system under harsh operating conditions satisfies the requirements, so the second calculated flow rate is used as the second branch flow rate for subsequent calculation. When the second calculated flow rate is less than the first preset flow rate, it indicates that the second calculated flow rate does not satisfy the first preset flow rate condition. In this case, the flow distribution of the system under harsh operating conditions does not satisfy the requirements. To address this, the system structure is adjusted to change the flow resistance of the system, thereby increasing the system flow rate and ensuring that the second calculated flow rate satisfies the flow distribution requirements of the system under harsh operating conditions. i.e., ensuring that the second calculated flow rate satisfies the first preset flow rate condition. Certainly, in other embodiments, the first preset flow rate condition may also be another condition, for example, when the second calculated flow rate is greater than the first preset flow rate, it indicates that the second calculated flow rate satisfies the second preset flow rate condition, and when the second calculated flow rate is not greater than the second preset flow rate, it indicates that the second calculated flow rate does not satisfy the second preset flow rate condition, which can be specifically adjusted as required.

Step S32 comprises:
S321: a second operating temperature of the cold plate on each branch under harsh operating conditions is calculated according to the second branch flow rate;
there are multiple methods for calculating the second operating temperature of the cold plate on the basis of the second branch flow rate, and the second operating temperature may be calculated by means of a heat transfer empirical formula, and may also be calculated by means of numerical simulation, which is not limited in the present invention.
S322: whether the heat dissipation evaluation of the system is qualified is determined according to the second operating temperature.

**In** the present embodiment, after determining the second branch flow rate, the second operating temperature of the cold plate under harsh operating conditions is calculated on the basis of the heat transfer empirical formula. Then, on the basis of the second operating temperature, it is determined whether the system heat dissipation evaluation is qualified, so that subsequently, on the basis of the evaluation result, it can be determined whether the system satisfies the requirements under harsh operating conditions, thereby ensuring that the system satisfies the requirements under harsh operating conditions.

Step S322 comprises:
S3221: when the second operating temperature satisfies a second preset temperature condition, it is determined that the heat dissipation evaluation of the system under harsh operating conditions is qualified;
the operating temperature of the cold plate should not exceed the design temperature, and therefore, when the second operating temperature is less than the second preset temperature, it is determined that the second operating temperature satisfies the second preset temperature condition. Certainly, in other embodiments, the second operating temperature may also be less than or equal to the second preset temperature.

S3222: when the second operating temperature does not satisfy the second preset temperature condition, it is determined that the heat dissipation evaluation of the system under harsh operating conditions is unqualified.

When the second operating temperature is greater than or equal to the second preset temperature, it indicates that the temperature of the cold plate exceeds the design temperature, then it is determined that the second operating temperature does not satisfy the second preset temperature condition. Certainly, in other embodiments, the second operating temperature is greater than the second preset temperature.

**In** the present embodiment, since the operating temperature of the cold plate should not exceed the design temperature, when the second operating temperature satisfies the second preset temperature condition, it indicates that the operating temperature of the cold plate satisfies the requirements, and thus the heat dissipation evaluation of the system under harsh operating conditions is determined to be qualified. When the second operating temperature does not satisfy the second preset temperature condition, it indicates that the operating temperature of the cold plate is higher than the design temperature, resulting in overheating of the cold plate, and therefore the heat dissipation evaluation of the system under harsh operating conditions is determined to be unqualified, and corresponding adjustment should be performed subsequently.

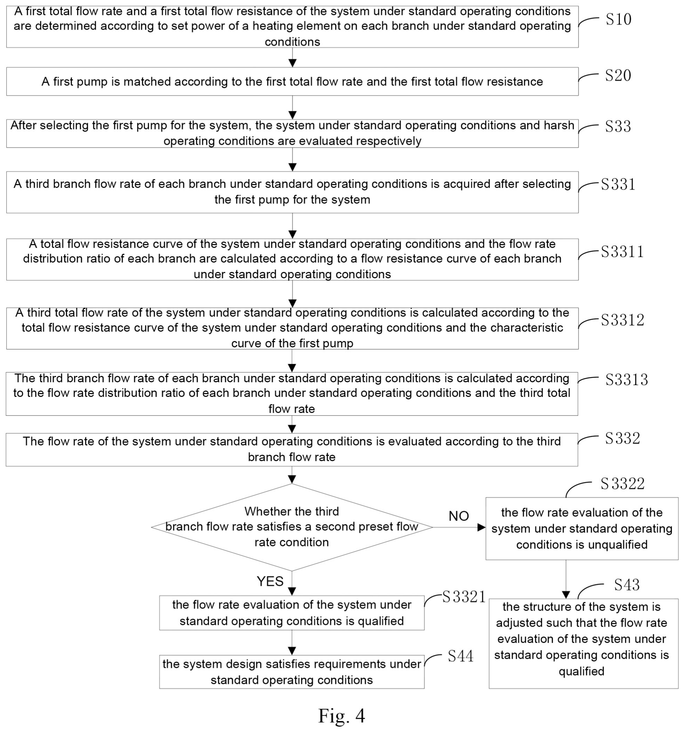

Please refer to Figs. 1 and 4, Fig. 4 is a schematic flowchart of a fourth embodiment of a design method for a two-phase liquid-cooling system according to an embodiment of the present invention.

**In** the present embodiment, step S30 comprises:
S33: after selecting the first pump for the system, the system under standard operating conditions and harsh operating conditions are evaluated respectively.

**In** the present embodiment, although the first pump is selected according to the first total flow rate and the first total flow resistance under standard operating conditions, theoretically, the selected first pump should satisfy the flow distribution requirements of the system under standard operating conditions. However, during the actual selection of the first pump, in the head-flow rate coordinate system, the head-flow rate curve of the first pump may not exactly pass through the points corresponding to the first total flow rate and the first total flow resistance; it could be located above the point or below the point. As a result, the selected first pump may exhibit deviations. Therefore, after selecting the first pump, the system is evaluated under standard operating conditions and harsh operating conditions respectively to ensure that the system satisfies the heat dissipation requirements under both standard operating conditions and harsh operating conditions.

The order of evaluating the system respectively under standard operating conditions and harsh operating conditions is not limited; it can be first evaluating the system under standard operating conditions and then under harsh operating conditions, or first under harsh operating conditions and then under standard operating conditions. However, since the selection of the first pump is calculated under standard operating conditions, it is advisable to first evaluate the system under standard operating conditions and then under harsh operating conditions, to avoid proceeding with subsequent calculations when the standard operating conditions do not satisfy the requirements, which would otherwise lead to the need for re-calculation later, thereby helping to save computation time.

Step S33 comprises:
S331: a third branch flow rate of each branch under standard operating conditions is acquired after selecting the first pump for the system;
S332: the flow rate of the system under standard operating conditions is evaluated according to the third branch flow rate;
Step S40 comprises:
   S43: when the flow rate evaluation of the system under standard operating conditions is unqualified, the structure of the system is adjusted such that the flow rate evaluation of the system under standard operating conditions is qualified;
   S44: when the flow rate evaluation of the system under standard operating conditions is qualified, it is determined that the system design satisfies requirements under standard operating conditions.

**In** the present embodiment, in order to make the flow distribution of the system satisfy requirements under standard operating conditions, after selecting the first pump for the system, the third branch flow rate on each branch under the standard operating conditions is acquired, and the flow rate of the system under standard operating conditions is evaluated according to the third branch flow rate, so as to determine whether the flow rate distribution of the system under standard operating conditions satisfies requirements, and when the flow rate evaluation of the system under standard operating conditions is qualified, it is determined that a system design satisfies requirements under standard operating conditions; and when the flow rate evaluation of the system under the standard operating condition is unqualified, it indicates that the flow rate distribution of the system does not satisfy the requirements. In this case, the flow resistance of the system is changed by adjusting the structure of the system, and accordingly, the flow rate evaluation of the system under standard operating conditions is qualified.

Theoretically, after the flow rate evaluation of the system under standard operating conditions is qualified, the heat dissipation of the system under standard operating conditions should also be evaluated. However, since the selection of the first pump is calculated under standard operating conditions, when the flow rate evaluation of the system under standard operating conditions is qualified, the heat dissipation evaluation of the system under standard operating conditions usually also satisfies the requirements. Therefore, there is no need to perform heat dissipation evaluation after the flow rate evaluation is qualified, thereby helping to reduce the amount of calculation.

Step S332 comprises:
S3321: when the third branch flow rate satisfies a second preset flow rate condition, it is determined that the flow rate evaluation of the system under standard operating conditions is qualified;
S3322: when the third branch flow rate does not satisfy the second preset flow rate condition, it is determined that the flow rate evaluation of the system under standard operating conditions is unqualified.

**In** the present embodiment, in order to ensure heat dissipation of the system, the flow rate on each branch is generally not less than the designed flow rate, therefore, when the flow rate of the third branch is not less than the second preset flow rate, it indicates that the flow rate of the third branch satisfies the second preset flow rate condition, in this case, the flow rate evaluation of the system under standard operating conditions is qualified, and when the flow rate of the third branch is less than the second preset flow rate, it indicates that the flow rate of the third branch does not satisfy the second preset flow rate condition, and in this case, it is determined that the flow rate evaluation of the system under standard operating conditions is unqualified. Certainly, in other embodiments, the second preset flow rate condition may also be another condition. For example, when the third branch flow rate is greater than the second preset flow rate, it indicates that the third branch flow rate satisfies the second preset flow rate condition; and when the third branch flow rate is not greater than the second preset flow rate, it indicates that the third branch flow rate does not satisfy the second preset flow rate condition, which can be specifically adjusted as required.

Step S331 comprises:
S3311: a total flow resistance curve of the system under standard operating conditions and the flow rate distribution ratio of each branch are calculated according to a flow resistance curve of each branch under standard operating conditions.

Under standard conditions, the flow resistance curve of each branch refers to the curve of the resistance of each resistance component on the branch varying with the flow rate, which is fitted from multiple data points. The flow resistance curve of each branch includes a single-phase flow resistance curve and a two-phase flow resistance curve. The single-phase flow resistance curve refers to the curve of the resistance of the resistance component varying with the flow rate under all-liquid conditions, and the two-phase flow resistance curve refers to the curve of the resistance of the resistance component varying with the flow rate under gas-liquid conditions. The flow resistance elements include frictional resistance, elbows, pipe crimping sections, and standard fittings (such as quick-disconnects + cold plate inlets/sealing blade inlets), etc. Additionally, there are multiple methods for calculating the flow resistance curve of each branch, which may be obtained by means of correlation formulas or may be obtained by means of numerical simulation, which is not limited in the embodiments of the present invention.

S3312: a third total flow rate of the system under standard operating conditions is calculated according to the total flow resistance curve of the system under standard operating conditions and the characteristic curve of the first pump.

The characteristic curve of the pump refers to the relationship of the head, power, efficiency, and the like of the system varying with the flow rate. In the head-flow rate coordinate system, the head-flow rate curve of the first pump is a downward-sloping curve, while the total flow resistance curve of the system is an upward-sloping curve. The intersection point of the two is the operating flow rate of the system under standard operating conditions. When the total flow resistance curve under standard operating conditions intersects with the head-flow rate curve of the first pump, the flow rate at the intersection point is the third total flow rate.

S3313: the third branch flow rate of each branch under standard operating conditions is calculated according to the flow rate distribution ratio of each branch under standard operating conditions and the third total flow rate.

**In** the present embodiment, the flow resistance curve of each branch is first obtained according to the resistance elements on each branch under standard operating conditions. Then, the total flow resistance curve of the system under standard operating conditions and the flow distribution ratio for each branch is calculated according to the flow resistance curve of each branch. Next, the third total flow rate of the system under standard operating conditions is determined according to the total flow resistance curve of the system under standard operating conditions and the characteristic curve of the first pump. Furthermore, the third branch flow rate for each branch is calculated according to the flow distribution ratio for each branch under standard operating conditions and the third total flow rate.

Additionally, the embodiments of the present invention also provide a two-phase liquid-cooling system, wherein the two-phase liquid-cooling system includes a pipeline system and a pump body, the pipeline system includes a main pipeline and a plurality of parallel branches, the plurality of branches are used to correspondingly cool a plurality of cold plates, and the pump body is provided on the main pipeline. The flow rate of the pump body can satisfy the heat dissipation and flow rate requirements of each branch under standard operating conditions and harsh operating conditions. **In** this manner, when the operating condition of the system changes, the total flow rate of the system changes synchronously, thereby reducing the flow rate change in branches that have not undergone any load change under harsh operating conditions, keeping the flow rate in branches that have not undergone any load change under harsh operating conditions stable, so that the branches that have not undergone any load change under harsh operating conditions can still dissipate heat normally, avoiding the impact of flow rate in branches that have not undergone any load change under harsh operating conditions from being affected by heat load changes in other branches. Thus, by means of reasonable design, the flow rate distribution in each branch of the system can satisfy the heat dissipation requirements of the system under different operating conditions.

The above are only the preferred embodiments of the present invention, and do not limit the patent scope of the present invention. Any equivalent structure or equivalent process transformation made by using content of the description and drawings of the present invention, or any application directly or indirectly applied to other related technical field, is similarly included in the scope of patent protection of the present invention.

## Claims

1. A design method for a two-phase liquid-cooling system, comprising:
determining, according to set power of a heating element on each branch under standard operating conditions, a first total flow rate and a first total flow resistance of the system under standard operating conditions;
matching a first pump according to the first total flow rate and the first total flow resistance;
evaluating the system at least in severe operating conditions after selecting the first pump for the system; and
determining, according to the evaluation result, whether the system design satisfies requirements.

2. The design method for the two-phase liquid-cooling system according to claim 1, wherein the step of determining, according to set power of a heating element on each branch under standard operating conditions, a first total flow rate and a first total flow resistance of the system under standard operating conditions comprises:
determining, according to set power of a heating element on each branch under standard operating conditions, a first branch flow rate for each branch under standard operating conditions; and
calculating the first total flow rate of the system under standard operating conditions according to the first branch flow rate for each branch.

3. The design method for the two-phase liquid-cooling system according to claim 2, wherein the step of determining, according to set power of a heating element on each branch under standard operating conditions, a first branch flow rate for each branch under standard operating conditions comprises:
calculating a first calculated flow rate for each branch according to the set power of the heating element on each branch under standard operating conditions;
calculating, according to the first calculated flow rate, a first operating temperature of a cold plate on each branch under standard operating conditions; and
determining, according to the first operating temperature, a first branch flow rate for each branch under standard operating conditions.

4. The design method for the two-phase liquid-cooling system according to claim 3, wherein the step of determining, according to the first operating temperature, a first branch flow rate for each branch under standard operating conditions comprises:
when the first operating temperature satisfies a first preset temperature condition, taking the first calculated flow rate as the first branch flow rate; and
when the first operating temperature does not satisfy the first preset temperature condition, adjusting a system structure such that the first operating temperature satisfies the first preset temperature condition.

5. The design method for the two-phase liquid-cooling system according to claim 2, wherein after the step of determining, according to the set power of the heating element on each branch under standard operating conditions, the first branch flow rate for each branch under standard operating conditions, the step of determining, according to the set power of the heating element on each branch under standard operating conditions, the first total flow rate and the first total flow resistance of the system under standard operating conditions comprises:
calculating a first branch flow resistance of each branch under standard operating conditions according to a flow resistance curve of each branch under standard operating conditions and the first branch flow rate; and
calculating a first total flow resistance of the system under standard operating conditions according to the first branch flow resistance.

6. The design method for the two-phase liquid-cooling system according to claim 1, wherein the step of evaluating the system at least under harsh operating conditions after selecting the first pump for the system comprises:
determining a second branch flow rate for each branch under harsh operating conditions after selecting the first pump for the system;
performing heat dissipation evaluation on the system under harsh operating conditions according to the second branch flow rate;
the step of determining, according to the evaluation result, whether the system design satisfies requirements, comprises:
when the heat dissipation evaluation of the system under harsh operating conditions is unqualified, adjusting the system structure or the selection of the first pump such that the system satisfies requirements under harsh operating conditions; and
when the heat dissipation evaluation of the system under harsh operating conditions is qualified, determining that the system design satisfies requirements under harsh operating conditions.

7. The design method for the two-phase liquid-cooling system according to claim 6, wherein the step of determining the second branch flow rate for each branch under harsh operating conditions after selecting the first pump for the system comprises:
after selecting the first pump for the system, calculating a total flow resistance curve of the system under harsh operating conditions and a flow rate distribution ratio of each branch according to the flow resistance curve of each branch under harsh operating conditions;
determining a second total flow rate of the system under harsh operating conditions according to the total flow resistance curve of the system under harsh operating conditions and a characteristic curve of the first pump;
calculating a second calculated flow of each branch according to the flow rate distribution ratio of branches under harsh operating conditions and the second total flow rate; and
determining the second branch flow rate of each branch under harsh operating conditions according to the second calculated flow rate.

8. The design method for the two-phase liquid-cooling system according to claim 7, wherein the step of determining the second branch flow rate of each branch under harsh operating conditions according to the second calculated flow rate comprises:
when the second calculated flow rate satisfies a first preset flow rate condition, taking the second calculated flow rate as the second branch flow rate; and
when the second calculated flow rate does not satisfy the first preset flow rate condition, adjusting the system structure such that the second calculated flow rate satisfies the first preset flow rate condition.

9. The design method for the two-phase liquid-cooling system according to claim 6, wherein the step of performing heat dissipation evaluation on the system under harsh operating conditions according to the second branch flow rate comprises:
calculating a second operating temperature of the cold plate on each branch under harsh operating conditions according to the second branch flow rate; and
determining, according to the second operating temperature, whether the heat dissipation evaluation of the system is qualified.

10. The design method for the two-phase liquid-cooling system according to claim 9, wherein the step of determining, according to the second operating temperature, whether the heat dissipation evaluation of the system is qualified comprises:
when the second operating temperature satisfies a second preset temperature condition, determining that the heat dissipation evaluation of the system under harsh operating conditions is qualified; and
when the second operating temperature does not satisfy the second preset temperature condition, determining that the heat dissipation evaluation of the system under harsh operating conditions is unqualified.

11. The design method for the two-phase liquid-cooling system according to claim 1, wherein the step of evaluating the system at least under harsh operating conditions after selecting the first pump for the system comprises:
after selecting the first pump for the system, evaluating the system under standard operating conditions and harsh operating conditions, respectively.

12. The method for designing the two-phase liquid-cooling system according to claim 11, wherein the step of evaluating the system under standard operating conditions after selecting the first pump for the system comprises:
acquiring a third branch flow rate of each branch under standard operating conditions after selecting the first pump for the system;
evaluating a flow rate of the system under standard operating conditions according to the third branch flow rate;
the step of determining, according to the evaluation result, whether the system design satisfies requirements comprises:
when the flow rate evaluation of the system under standard operating conditions is unqualified, adjusting the structure of the system such that the flow rate evaluation of the system under standard operating conditions is qualified; and
when the flow rate evaluation of the system under standard operating conditions is qualified, determining that the system design satisfies requirements under standard operating conditions.

13. The design method for the two-phase liquid-cooling system according to claim 12, wherein the step of evaluating the flow rate of the system under standard operating conditions according to the third branch flow rate comprises:
when the third branch flow rate satisfies a second preset flow rate condition, determining that the flow rate evaluation of the system under standard operating conditions is qualified; and
when the third branch flow rate does not satisfy the second preset flow rate condition, determining that the flow rate evaluation of the system under standard operating conditions is unqualified.

14. The design method for the two-phase liquid-cooling system according to claim 12, wherein the step of acquiring a third branch flow rate of each branch under standard operating conditions after selecting the first pump for the system comprises:
according to a flow resistance curve of each branch under standard operating conditions, calculating a total flow resistance curve of the system under standard operating conditions and the flow rate distribution ratio of each branch;
calculating a third total flow rate of the system under standard operating conditions according to the total flow resistance curve of the system under standard operating conditions and the characteristic curve of the first pump; and
calculating the third branch flow rate of each branch under standard operating conditions according to the flow rate distribution ratio of each branch under standard operating conditions and the third total flow rate.

15. A two-phase liquid-cooling system, comprising:
a pipeline system, comprising a main pipeline and a plurality of parallel branches, the plurality of branches being used for correspondingly cooling a plurality of cold plates; and
a pump body, provided on the main pipeline;
wherein the flow rate of the pump body can satisfy the heat dissipation and flow rate requirements of each of the branches under both standard operating conditions and harsh operating conditions.
